# EUROPÄISCHE PATENTANMELDUNG

(11) **EP 1 168 901 A2**
(43) Veröffentlichungstag der Anmeldung: **02.01.2002**
(21) Anmeldenummer: 01112310.6
(22) Anmeldetag: 19.05.2001
(51) Int. Cl.: H05K 3/46, H01F 17/00

(54) **Mehrlagen-Leiterplatten-Verbundkörper und Verfahren zu dessen Herstellung**

(30) Priorität: 24.06.2000 DE 10030922
(71) Anmelder: rotra Leiterplatten Produktions- und Vetriebs-GmbH, 90471 Nürnberg (DE)
(72) Erfinder: Opitz, Rudi Walter, 90522 Oberasbach (DE); Stuckmann, Walter Paul Fritz, 90513 Zirndorf (DE)
(74) Vertreter: Rau, Albrecht

(57) **Zusammenfassung**

Mehrlagen-Leiterplatten-Verbundkörper (5) mit mindestens zwei flächig übereinander angeordneten Leiterplatten (9), welche jeweils aufweisen eine elektrisch isolierende Trägerplatte (10), elektrisch leitende Leiterbahnen (11), die auf mindestens einer Seite der Trägerplatte (10) vorgesehen sind und Ausnehmungen (12), die seitlich von den Leiterbahnen (11) und zur Trägerplatte (10) hin durch die Trägerplatte (10) begrenzt werden, und mit mindestens einer zwischen den Leiterplatten (9) angeordneten Verbundfolie (14) zum Verbinden der Leiterplatten (9), wobei die zwischen den Trägerplatten (10) der jeweiligen Leiterplatten (9) angeordneten Ausnehmungen (12) im wesentlichen vollständig mit einer Kunstharz-Masse (13) ausgefüllt sind und wobei die mindestens zwei Leiterplatten (9) und die mindestens eine Verbundfolie (14) miteinander verpreßt sind.

## Beschreibung

Die Erfindung betrifft einen Mehrlagen-Leiterplatten-Verbundkörper sowie ein Verfahren zu dessen Herstellung und zur Herstellung von planaren Transformatoren und planaren Spulen auf der Basis der Mehrlagen-Leiterplatten-Verbundkörper.

Mehrlagen-Leiterplatten-Verbundkörper sind unter der Bezeichnung "Multilayer" seit längerem bekannt. Hierbei werden mehrere Lagen von Leiterplatten übereinander angeordnet und durch sogenannte "Prepregs" miteinander verbunden. Die typische Dicke der hierbei verwendeten foto- und ätztechnisch strukturierten Basis-Leiterbahnen liegt bei ungefähr 18 µm bis 70 µm, so daß die zwischen den Leiterbahnen liegenden Ausnehmungen durch Kunstharz, das beim Verpressen aus den Prepregs austritt, ausgefüllt werden. Aufgrund von Entwicklungen im Automobilbereich hat sich der Energiebedarf bei der elektrischen Versorgung im Fahrzeug erhöht, so daß neuartige Hochleistungs-Netzteile erforderlich sind. Die bekannten Leiterplattensysteme mit 18 µm bis 70 µm dicken Kupferleiterbahnen sind für höhere Ströme aufgrund der begrenzten Leitfähigkeit ungenügend. Deshalb sind Leiterplatten entwickelt worden, deren Leiterbahnen eine Dicke von 400 µm aufweisen. Derartige Leiterplatten können mit den bisher existierenden Verfahren nicht flächig miteinander verbunden werden, da das aus den Prepregs beim Verpressen austretende Kunstharz nicht genügt, um unter Einhaltung der vorgegebenen Gesamtdicken der Mehrlagen-Leiterplatten die Ausnehmungen zwischen den Leiterplatten vollständig zu füllen. Hierdurch kommt es vor allem bei thermischen Belastungen zu einer Delamination der Mehrlagen-Leiterplatten. Ferner treten zwischen den Leiterbahnen einer Leiterplatte und zwischen den Leiterbahnen benachbarter Leiterplatten Spannungsüberschläge auf, da eine gleichmäßige Isolation durch Kunstharz nicht gewährleistet ist.

Der Erfindung liegt die Aufgabe zugrunde, einen Mehrlagen-Leiterplatten-Verbundkörper sowie ein Verfahren zu dessen Herstellung zu schaffen, bei dem die einzelnen Leiterplatten dauerhaft und gleichmäßig miteinander verbunden sind.

Die Aufgabe wird durch die Merkmale der Ansprüche 1 und 7 gelöst.

Weitere vorteilhafte Ausgestaltungen der Erfindung ergeben sich aus den Unteransprüchen.

Zusätzliche Merkmale und Einzelheiten ergeben sich aus der Beschreibung von fünf Ausführungsbeispielen anhand der Zeichnung. Es zeigen:

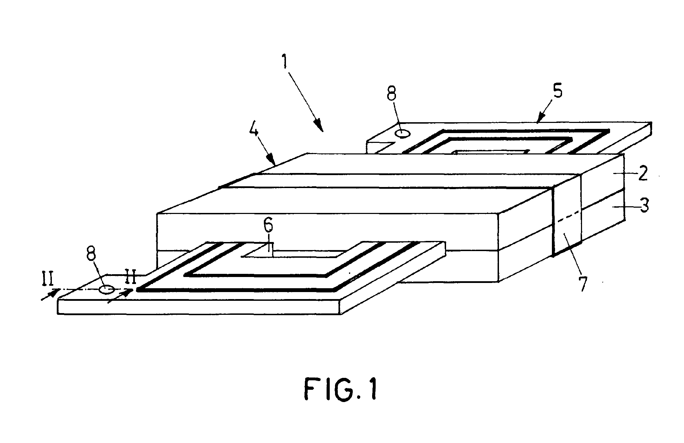

- Fig. 1: eine Draufsicht auf einen Transformator mit einem Mehrlagen-Leiterplatten-Verbundkörper,
- Fig. 2: einen Teil-Querschnitt gemäß der Schnittlinie II-II in Fig. 1 und
- Fig. 3: eine Ausschnittvergrößerung eines Querschnitts durch den Mehrlagen-Leiterplatten-Verbundkörper gemäß Fig. 1.

Ein Transformator 1 weist einen aus einer ersten Hälfte 2 und einer zweiten Hälfte 3 bestehenden quaderförmigen Ferrit-Körper 4 auf. Zwischen den zwei ggf. unsymmetrischen Hälften 2, 3 ist in entsprechenden Ausnehmungen ein Mehrlagen-Leiterplatten-Verbundkörper 5 angeordnet, der nachfolgend als Mehrlagen-Leiterplatte 5 bezeichnet wird. Die Mehrlagen-Leiterplatte 5, die in Draufsicht im wesentlichen einen rechteckigen Querschnitt mit einer mittig angeordneten rechteckigen Öffnung 6 aufweist, steht auf zwei gegenüberliegenden Seiten über den Ferrit-Körper 4 hervor. Die Mehrlagen-Leiterplatte 5 kann auch einen runden Querschnitt mit einer mittig angeordneten rechteckigen oder runden Öffnung 6 aufweisen. Die beiden Hälften 2, 3 sind derart ausgebildet, daß die einander zugewandten Stirnflächen ohne Luftspalt aufeinander liegen, damit durch anderenfalls entstehende Luftspalte keine Verluste im Transformator 1 entstehen. Es ist auch möglich, die beiden Hälften 2, 3 so auszubilden, daß die einander zugewandten Stirnflächen mit einem definierten Abstand zueinander liegen. Die beiden Hälfte 2, 3 werden durch ein beide umgebendes Band 7 zusammengedrückt. Zum Anschluß des Transformators 1 sind in der Mehrlagen-Leiterplatte 5 Anschluß-Bohrungen 8 vorgesehen.

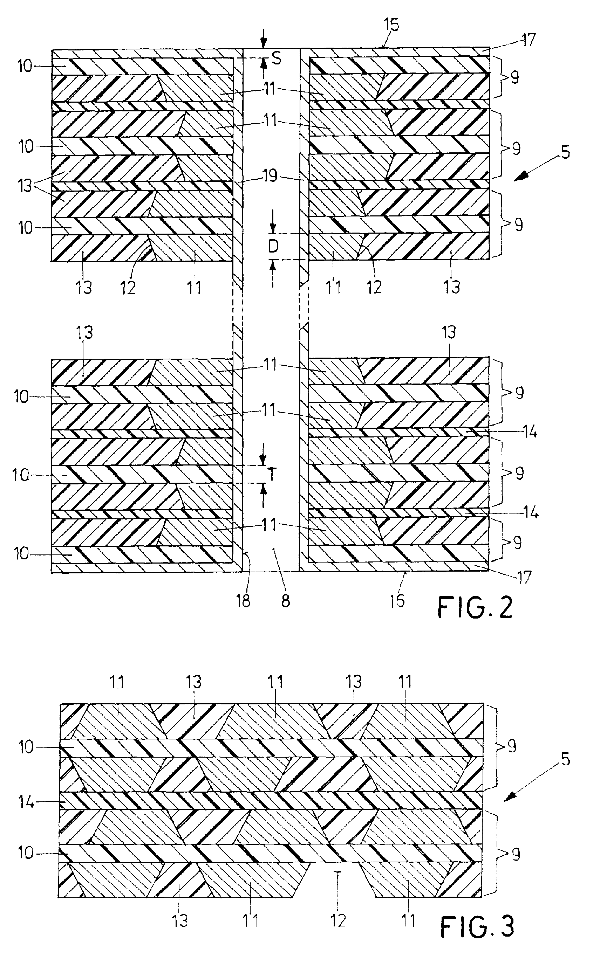

Im folgenden wird unter Bezugnahme auf die Fig. 2 und 3 der Aufbau der Mehrlagen-Leiterplatte 5 beschrieben. Die Mehrlagen-Leiterplatte 5 besteht im Inneren aus mehreren übereinander angeordneten und miteinander mechanisch und elektrisch verbundenen Leiterplatten 9. Jeweils eine Leiterplatte 9 weist eine elektrisch isolierende Trägerplatte 10 auf, auf der auf einer Seite oder auf beiden Seiten metallische Leiterbahnen 11 vorgesehen sind, deren Verlauf durch siebdrucktechnische oder fototechnische Druck-Ätzprozesse festgelegt wurden. Die Trägerplatte 10 weist eine Dicke T von 200 µm auf, wobei die Dicke T zum einen den Festigkeitsanforderungen an die Trägerplatte 10 und zum anderen den geforderten elektrischen Isolationseigenschaften und der geforderten Durchschlagfestigkeit angepaßt werden kann. Die Leiterbahnen 11 bestehen vorzugsweise aus Kupfer und weisen eine Dicke D auf, für die gilt: D ≥ 100 µm, insbesondere D ≥ 200 µm, insbesondere D ≥ 300 µm und besonders vorteilhaft D ≅ 400 µm. Bei den Leiterbahnen der bevorzugten Dicke D ≅ 400 µm handelt es sich um Leiterbahnen einer Dicke, die ungefähr um einen Faktor 5 bis 10 dicker sind als die in der Mikroelektronik üblichen Leiterbahnen. Dies erlaubt die Verwendung bei größeren Strömen und höheren Leistungen, insbesondere einer an der Mehrlagen-Leiterplatte 5 anliegenden Spannung von 42 Volt. Zwischen den Leiterbahnen 11 auf jeweils einer Seite einer Trägerplatte 10 sind nach außen hin offene Ausnehmungen 12 vorgesehen, die seitlich durch benachbarte Leiterbahnen 11 und zur Trägerplatte 10 hin durch diese begrenzt werden. Die Ausnehmungen 12 entstehen dadurch, daß aus einer vollständig metallisch beschichteten Trägerplatte 10 die Leiterbahnen 11 in der Form erzeugt werden, daß das zwischen ihnen liegende Metall weggeätzt wird.

Zum Verbinden der einzelnen übereinander angeordneten Leiterplatten 9 sind die Ausnehmungen 12 im wesentlichen vollständig mit einer Kunstharz-Masse 13 ausgefüllt. Dies bedeutet, daß die Ausnehmungen zu mehr als 90 %, insbesondere mehr als 98 % und besonders bevorzugt mehr als 99,9 % mit der Kunstharz-Masse 13 ausgefüllt sind. Bei der Kunstharz-Masse 13 handelt es sich bevorzugt um ein Epoxydharz. Die Kunstharz-Masse 13 soll keine Lösungsmittel enthalten, beim Aushärten nicht schrumpfen, thermisch aushärtbar sein und darüber hinaus kalt erarbeitet werden können. Wichtig ist, daß die Kunstharz-Masse 13 die Ausnehmung 12 ohne Freilassung von Räumen und ohne die Bildung von Blasen ausfüllt, um sicherzustellen, daß zwischen benachbarten Leiterbahnen 11 derselben Leiterplatte 9 und übereinanderliegenden Leiterbahnen 11 eine ausreichende und definierte Isolation besteht.

Zwischen übereinander angeordneten Leiterplatten 9 sind eine oder mehrere, unmittelbar aufeinanderliegende Verbundfolien 14 vorgesehen, die in der Fachsprache als "Prepreg" bezeichnet werden. Bei den Verbundfolien handelt es sich um kunstharzimprägnierte Glasfasergewebe. In Abhängigkeit von der zwischen aufeinanderliegenden Leiterplatten 9 erforderlichen Isolation können eine oder mehrere Verbundfolien 14 verwendet werden. Auf der Oberseite 15 und Unterseite 16 der Mehrlagen-Leiterplatte 5 weist die jeweils äußerste Leiterplatte 9 nach außen hin keine Leiterbahnen 11 auf. Dies ermöglicht es, eine möglichst glatte Oberfläche zu schaffen. Es ist alternativ möglich, auf der jeweiligen Außenseite der obersten und untersten Leiterplatte 9 Leiterbahnen vorzusehen, die dünner sind, insbesondere 18 µm bis 70 µm Kupfer, als die oben mit der Dicke D beschriebenen Leiterbahnen 11. Auf diese Weise ist es möglich, die leistungsführenden Teile innerhalb der Mehrlagen-Leiterplatte 5 anzuordnen, wohingegen auf der Oberseite 15 und der Unterseite 16 elektronische Bauelemente vorgesehen sein können. Die Mehrlagen-Leiterplatte 5 weist an der Oberseite 15 und an der Unterseite 16 jeweils eine metallische Deckschicht 17 auf, die vorzugsweise aus Kupfer besteht und eine Dicke S von ungefähr 100 µm aufweist. Die Deckschicht 17 wird durch elektrolytisch abgeschiedenes Kupfer, verstärkt um Zinn, Nickel, Gold oder Silber als Oberflächenschutz, gebildet.

Die Mehrlagen-Leiterplatte 5 ist thermisch verpreßt. Sie besitzt sehr gute mechanische Eigenschaften. Insbesondere ist sie sehr stabil und insofern sind die innenliegenden Leiterplatten vor einer mechanischen Beschädigung geschützt. Thermische Belastungen führen nicht zu einer Delamination der einzelnen Leiterplatten 9, d. h. einer Ablösung von Schichten. Es ist möglich, die Wicklungen des Trafos einerseits und die Steuerelektronik andererseits in eine Mehrlagen-Leiterplatte 5 zu integrieren, wobei die leistungsführenden Spulen in der Mehrlagen-Leiterplatte 5 und die Steuerelektronik auf dieser angeordnet ist. Die Mehrlagen-Leiterplatte 5 ist fräsbar und durchbohrbar und kann insofern leicht weiterbearbeitet werden.

Die Mehrlagen-Leiterplatte 5 weist beidseitig offene Anschluß-Bohrungen 8 auf. Die Innenwand 18 der jeweiligen Anschluß-Bohrung 8 weist einen elektrolytisch abgeschiedenen Kontaktierungs-Überzug 19 aus Metall, insbesondere Kupfer, auf. Dieser ist durch die Art des elektrolytischen Auftrags elektrisch leitend mit den übereinanderliegenden Leiterbahnen 11 verbunden, die direkt an die jeweilige Anschluß-Bohrung 8 angrenzen. Auf diese Weise ist es möglich, Signale oder höhere Ströme auf bestimmte Leiterplatten 9 der Mehrlagen-Leiterplatte 5 zu geben bzw. von diesen aufzunehmen.

Im folgenden wird ein Verfahren zur Herstellung der Mehrlagen-Leiterplatte 5 mittels Siebdruck-Verfahren gemäß einer ersten Ausführungsform beschrieben. Zunächst werden durch lithografische Behandlung Leiterplatten 9 hergestellt, die auf einer Seite oder auf beiden Seiten Kupfer-Leiterbahnen 11 aufweisen, die durch Ausnehmungen 12 voneinander getrennt sind. Zum Ausfüllen der Ausnehmungen 12 wird ein Siebdruck-Verfahren angewandt, wobei statt Farbe die Kunstharz-Masse 13 verwendet wird. Das für das Verfahren verwendete Sieb weist genau an den Stellen Öffnungen auf, an denen die Ausnehmungen 12 der verschiedenen Leiterplatten 9 angeordnet sind. Bei dem Verfahren wird durch das Sieb Kunstharz in die Ausnehmungen 12 gedrückt, so daß diese vollständig ausgefüllt sind. Anschließend wird durch eine Rakel die Oberfläche der Leiterplatte 9 glattgezogen. Dann wird die beschichtete Leiterplatte 9 in einem thermischen Prozeß vorgehärtet, vorzugsweise mittels Umlufttrocknung mit einer Temperatur von 100 °C bis 150 °C für einen Zeitraum von 15 Minuten bis 60 Minuten. Auf die mit Kunstharz-Masse aufgefüllte und vorgehärtete Leiterplatte 9 werden eine oder mehrere Lagen der Verbundfolie 14 aufgebracht. Hierauf wird eine weitere Leiterplatte 9, deren Ausnehmungen 12 nach dem zuvor beschriebenen Verfahren ausgefüllt wurden, aufgebracht. Das Verfahren wird fortgesetzt, bis die gewünschte Zahl von Leiterplatten 9 erreicht ist. Anschließend wird die Gesamtanordnung von Leiterplatten 9 unter Wärmeeinwirkung verpreßt, so daß sowohl die Kunstharz-Masse 13 in den Ausnehmungen 12 als auch das Kunstharz in der Verbundfolie 14 ohne Freisetzung von Lösungsmitteln aushärtet.

Gemäß einer zweiten Ausführungsform wird zum Ausfüllen der Ausnehmungen 12 ein Lotpastendruck-Verfahren oder auch Schablonendruck-Verfahren verwendet. Hierbei wird kein Sieb, sondern eine gegenüber dem Sieb sehr viel kleinere, haltbarere feste Blech- oder Stahlschablone verwendet. Durch diese wird die Kunstharz-Masse 13 in die Ausnehmungen 12 gedrückt. Ansonsten entspricht das Herstellungsverfahren dem gemäß der ersten Ausführungsform.

Gemäß einer dritten Ausführungsform wird die pastenförmige Kunstharz-Masse auf die gesamte Oberfläche einer Leiterplatte 9 gegeben und durch Walzen in die Ausnehmungen 12 gedrückt. Anschließend wird die Oberfläche mit einer Rakel abgezogen. Vorteilhaft gegenüber den ersten beiden Ausführungsformen ist, daß die so erzeugte Oberfläche vollkommen eben ist. Dies ist beim Sieb- oder Schablonen-Druck nicht gewährleistet, wenn das Sieb bzw. die Schablone leicht versetzt auf die Leiterplatte aufgebracht wird und auf den Leiterbahnen 11 zusätzliche, hervorstehende Schichten aus Kunstharz-Masse 13 entstehen.

Gemäß einer vierten Ausführungsform kann zum Befüllen der Ausnehmungen 12 ein Verfahren verwendet werden, das bei der Halbleiterherstellung zum Füllen von Löchern und Bohrungen mit Lack verwendet wird. In einem Kunstharz-Bad wird zwischen mehreren, parallel zueinander in einer Ebene angeordneten, rotierenden Walzen eine stehende Welle erzeugt. Die Leiterplatte wird mit den zu füllenden Ausnehmungen 12 nach unten über diese Welle zwangsgeführt, so daß der Wellenberg die Leiterplatte 9 berührt und die Kunstharz-Masse 13 in die Ausnehmungen 12 eindringt.

Gemäß einer fünften Ausführungsform kann zum Befüllen der Ausnehmungen 12 das nachfolgend beschriebene Verfahren verwendet werden. Hierbei wird bei jeder Leiterplatte 9 die Kunstharz-Masse sowohl auf der Oberseite als auch auf der Unterseite der Leiterplatte 9 aufgebracht. Es ist jedoch auch möglich, die Kunstharzmasse nur auf einer Seite aufzubringen. Zunächst wird die Kunstharz-Masse in einem Streifen von 1 cm bis 2 cm Breite und einer Länge, die der Breite der Leiterplatte 9 entspricht, auf eine Kunststoffolie aufgetragen. Die Kunststoffolie kann aus Polyester bestehen und ist bevorzugt 25 µm bis 125 um dick. Die Menge der Kunstharz-Masse ist derart bemessen, daß sie bei einer gleichmäßigen Verteilung über die Oberfläche der Leiterplatte 9 genügt, um die Ausnehmungen 12 vollständig zu füllen. Anschließend wird die Leiterplatte 9 auf die mit einem Kunstharz-Masse-Streifen versehene Trägerfolie gelegt, so daß der Kunstharz-Masse-Streifen die Leiterplatte 9 entlang der vorderen Kante über die gesamte Breite der Leiterplatte 9 kontaktiert. Dann wird ein Kunstharz-Masse-Streifen auf die andere Seite der Leiterplatte 9 an der ebenfalls vorderen Kante der Leiterplatte 9 in 1 cm bis 2 cm Breite über die gesamte Breite der Leiterplatte 9 aufgetragen, dessen Menge genügt, um die Ausnehmungen 12 auf dieser Seite der Leiterplatte vollständig auszufüllen. Anschließend wird die mit Kunstharz-Masse versehene Seite der Leiterplatte 9 ebenfalls mit einer Abdeckfolie, z.B. aus Polyester, vorzugsweise 25 µm bis 125 µm dick, abgedeckt. Es befinden sich nun auf gegenüberliegenden Seiten im Bereich der vorderen Kante der Leiterplatte 9 Kunstharz-Masse-Streifen auf der Oberseite und Unterseite, die jeweils durch eine Folie abgedeckt sind. Anschließend wird das Paket aus Kunststoffolie, Kunstharz-Masse, Leiterplatte 9, Kunstharz-Masse, Kunststoffolie durch einen sogenannten Hot-Roll-Laminator geführt, der unter anderem mehrere beheizbare Walzen aufweist, zwischen denen das Paket durchgeführt wird. Hierdurch kommt es zu einer Verteilung der Kunstharz-Masse über die gesamte Oberseite und Unterseite der Leiterplatte 9, wodurch die Ausnehmungen 12 auf der Ober- und Unterseite der Leiterplatte 9 vollständig gefüllte werden. Anschließend wird die Kunstharz-Masse analog dem zum ersten Ausführungsbeispiel beschriebenen Verfahren vorgehärtet. Nach der Vorhärtung kann die temperatur- und kunstharz-masse-beständige Kunststoffolie auf beiden Seiten abgezogen werden. Das Zusammenfügen mehrer Leiterplatten aufeinander erfolgt dann beispielsweise nach dem zum ersten Ausführungsbeispiel beschriebenen Verfahren. Besonders vorteilhaft ist, daß auch bei doppelseitiger Beschichtung eine saubere Handhabung aufgrund der Kunststoffolien möglich ist. Die Kunstharz-Schichtdicke läßt sich gleichmäßig einstellen; die erzeugten Oberflächen sind sehr planar. Gegenüber der vierten Ausführungsform besteht der Vorteil, daß nur hun-dertprozentig neues Kunstharz verwendet wird, das nicht durch vorherige Beschichtungen verunreinigt sein kann. In dem Hot-Roll-Laminator ist eine genaue Regelung von Druck und Temperatur zur Einstellung der optimalen Kunstharz-Viskosität möglich. Ein automatisierter, kontinuierlicher Prozeßablauf ist möglich. Die Dosierung der Kunstharz-Masse ist einfach regelbar.

## Patentansprüche

1. Mehrlagen-Leiterplatten-Verbundkörper (5)
a) mit mindestens zwei flächig übereinander angeordneten Leiterplatten (9), welche jeweils aufweisen
i) eine elektrisch isolierende Trägerplatte (10),
ii) elektrisch leitende Leiterbahnen (11), die auf mindestens einer Seite der Trägerplatte (10) vorgesehen sind und
iii) Ausnehmungen (12), die seitlich von den Leiterbahnen (11) und zur Trägerplatte (10) hin durch die Trägerplatte (10) begrenzt werden, und
b) mit mindestens einer zwischen den Leiterplatten (9) angeordneten Verbundfolie (14) zum Verbinden der Leiterplatten (9),
c) wobei die zwischen den Trägerplatten (10) der jeweiligen Leiterplatten (9) angeordneten Ausnehmungen (12) im wesentlichen vollständig mit einer Kunstharz-Masse (13) ausgefüllt sind und
d) wobei die mindestens zwei Leiterplatten (9) und die mindestens eine Verbundfolie (14) miteinander verpreßt sind.

2. Mehrlagen-Leiterplatten-Verbundkörper (5) gemäß Anspruch 1, **dadurch gekennzeichnet, daß** die Leiterbahnen (11) eine Dicke D aufweisen, für die gilt: D ≥ 100 µm, insbesondere D ≥ 300 µm und besonders bevorzugt D ≈ 400 µm.

3. Mehrlagen-Leiterplatten-Verbundkörper (5) gemäß Anspruch 1 oder 2, **dadurch gekennzeichnet, daß** die zwischen den Trägerplatten (10) der jeweiligen Leiterplatten (9) angeordneten Ausnehmungen (12) zu mehr als 90 %, insbesondere zu mehr als 98 % und besonders bevorzugt zu mehr als 99,9 % ausgefüllt sind.

4. Mehrlagen-Leiterplatten-Verbundkörper (5) gemäß einem der vorangehenden Ansprüche, **dadurch gekennzeichnet, daß** die zwischen den Leiterplatten (9) angeordnete Kunstharz-Masse (13) im wesentlichen blasenfrei ist.

5. Mehrlagen-Leiterplatten-Verbundkörper (5) gemäß einem der vorangehenden Ansprüche, **dadurch gekennzeichnet, daß** die Verbundfolie (14) ein mit Kunstharz imprägniertes Glasfasergewebe aufweist.

6. Mehrlagen-Leiterplatten-Verbundkörper (5) gemäß einem der vorangehenden Ansprüche, **dadurch gekennzeichnet, daß** zwischen der Kunstharz-Masse (13), den Leiterbahnen (11) und der Verbundfolie (14) eine innige Verbindung besteht.

7. Verfahren zur Herstellung eines Mehrlagen-Leiterplatten-Verbundkörpers (5) gemäß einem der vorangehenden Ansprüche, umfassend die folgenden Schritte:
a) Bereitstellen von mindestens zwei Leiterplatten (9), welche jeweils aufweisen
i) eine elektrisch isolierende Trägerplatte (10),
ii) elektrisch leitende Leiterbahnen (11), die auf mindestens einer Seite der Trägerplatte (10) vorgesehen sind, und
iii) Ausnehmungen (12), die seitlich von den Leiterbahnen (11) und zur Trägerplatte (10) hin durch die Trägerplatte (10) begrenzt werden,
b) im wesentlichen vollständiges Auffüllen der Ausnehmungen (12) der Leiterplatten (9),
c) Aufbringen mindestens einer Verbundfolie (14) auf eine erste Leiterplatte (9),
d) Aufbringen einer zweiten Leiterplatte (9) auf die Verbundfolie (14), und
e) Verpressen der mindestens zwei Leiterplatten (9) und der mindestens einen Verbundfolie (14).

8. Verfahren gemäß Ansprach 7, **dadurch gekennzeichnet, daß** die Ausnehmungen (12) nach einem Siebdruck-Verfahren mit Kunstharz-Masse (13) gefüllt werden.

9. Verfahren gemäß Anspruch 7, **dadurch gekennzeichnet, daß** die Ausnehmungen (12) nach einen Schablonendruck-Verfahren mit Kunstharz-Masse (13) gefüllt werden.

10. Verfahren gemäß Anspruch 7, **dadurch gekennzeichnet, daß** die Ausnehmungen (12) nach einem Walzen-Beschichtungsverfahren mit Kunstharz-Masse (13) gefüllt werden.

11. Verfahren gemäß Anspruch 7, **dadurch gekennzeichnet, daß** entlang mindestens einer Kante der Leiterplatte (9) ein Streifen aus Kunstharz-Masse aufgetragen wird und anschließend der Streifen Kunstharz-Masse und die entsprechende Seite der Leiterplatte (9) mit einer Folie abgedeckt werden.

12. Verfahren gemäß Anspruch 11, **dadurch gekennzeichnet, daß** der Verfahrensschritt gemäß Anspruch 11 auf beiden Seiten der Leiterplatte (9) durchgeführt wird.

13. Verfahren gemäß Anspruch 11 oder 12, **dadurch gekennzeichnet, daß** die Leiterplatte (9) mit dem Streifen aus Kunstharz-Masse und der Folie durch einen Laminator zur gleichmäßigen Verteilung der Kunstharz-Masse auf der Oberfläche der Leiterplatte (9) geführt wird.

14. Transformator (1) umfassend
a) einen Mehrlagen-Leiterplatten-Verbundkörper (5) gemäß einem der Ansprüche 1 bis 6 und
b) einen den Mehrlagen-Leiterplatten-Verbundkörper (5) zumindest teilweise umgebenden Ferrit-Körper (4).
